# EUROPÄISCHE PATENTANMELDUNG

(11) **EP 1 298 802 A1**
(43) Veröffentlichungstag der Anmeldung: **02.04.2003**
(21) Anmeldenummer: 01810952.0
(22) Anmeldetag: 28.09.2001
(51) Int. Cl.: H03K 17/10, H03K 17/04, H03K 17/0812

(54) **Verfahren zum Ansteuern eines Leistungshalbleiters**

(71) Anmelder: ABB Schweiz AG, 5400 Baden (CH)
(72) Erfinder: Apeldoorn, Oscar, 5618 Bettwil (CH); Carroll, Eric, 5725 Leutwil (CH); Streit, Peter, 8967 Widen (CH); Weber, André, 4600 Olten (CH)
(74) Vertreter: ABB Patent Attorneys

(57) **Zusammenfassung**

Der Integrated-Gate Dual-Transistor (IGDT) weist zwei steuerbare Gates (G1, G2) auf, wobei ein erstes Gate (G1) kathodenseitig angebracht ist und über einen niderinduktiven ersten Gateanschluss mit einem ersten Gatestrom angesteuert wird, und ein zweites Gate (G2) anodenseitig angebracht ist und über einen niderinduktiven zweiten Gateanschluss mit einem zweiten Gatestrom angesteuert wird. Im Ausschaltvorgang des IGDTs wird die Anstiegsgeschwindigkeit der Spannung über dem IGDT über die beiden Gates begrenzt. Begrenzung der Anstiegsgeschwindigkeit der Spannung über dem IGDT verhindert, dass in einer Serienschaltung IGDTs unterschiedlich schnell Spannungen aufbauen, und so ungleiche Belastungen die einzelnen IGDTs überhitzen und zerstören.

## Beschreibung

### Technisches Gebiet

Die Erfindung bezieht sich auf das Gebiet der Hochleistungs-Elektronik.
Sie betrifft ein Verfahren zum Ansteuern eines Leistungshalbleiterelements, wobei das Leistungshalbleiterelement ein Integrated-Gate Dual-Transistor (IGDT) mit zwei steuerbaren Gates ist, wobei ein erstes Gate kathodenseitig angebracht ist und über einen niederinduktiven ersten Gateanschluss mit einem ersten Gatestrom angesteuert wird, und ein zweites Gate anodenseitig angebracht ist und über einen niederinduktiven zweiten Gateanschluss mit einem zweiten Gatestrom angesteuert wird.
Weiter betrifft sie eine Schaltungsanordnung zum Durchführen diese Verfahrens.

### Stand der Technik

Im Bereich der Leistungselektronik hat die Suche nach dem optimalen, abschaltbaren Halbleiterelement verschiedene schnelle, leistungsstarke Halbleiterelemente hervorgebracht. Der Weg zu noch grösseren geschalteten Leistungen führt für die immer kleiner werdenden Halbleiterelemente über die Reduktion der Verluste. Sowohl dynamischen Schaltverluste als auch stationäre Leit- bzw. Sperrverluste führen zu hohen Temperaturen und beschränken Schaltleistung und -frequenz.
Der Gate Turn-Off thyristor (GTO) ist ein seit mehreren Jahren bekanntes abschaltbares Halbleiterelement mit charakteristischer Freiwerdezeit und einer Abschaltverstärkung grösser als 1. Zum Abschalten wird an ein kathodenseitiges Gate des GTO ein Abschaltbefehl in Form eines positiven Stromes angelegt. Der Gatestrom wird von einer Gateansteuerung gesteuert. Die Freiwerde- oder Reaktionszeit zwischen dem Abschaltbefehl und dem eigentlichen Abschaltprozess beträgt ein Vielfaches der eigentlichen Schaltdauer und hängt sowohl vom aktuellen Betriebszustand, insbesondere von der zu schaltenden Stromstärke, als auch von der Gateansteuerung ab. Dies macht insbesondere snubberlose Abschaltung von GTOs unmöglich, und Serieschaltung und Parallelschaltung sehr aufwendig.

Der Dual-Gate GTO wie er in *Tsuneo Ogura* et *al., "High-Frequency 6000V Double Gate GTOs", 1993, IEEE Transactions on Electron Devices, Vol 40. NO.3*, beschrieben ist, weist im Vergleich zum normalen GTO anodenseitig ein zusätzliches Gate auf wodurch sich die Möglichkeit ergibt, den Abschaltvorgang durch je eine Gateansteuerungen auf beiden Seiten des Elementes einzuleiten. Dem Vorteil der deutlich reduzierten Abschaltverluste steht hier die deutlich aufwendigeren Gateansteuerung gegenüber. Denn wenn schon der GTO erhebliche, vom Betriebszustand abhängige Reaktionszeiten aufweist, erstaunt nicht, dass der Dual-Gate GTO nochmals komplexer reagiert. Kathodenseitig und anodenseitig ergeben sich deutlich unterschiedliche Freiwerdezeiten, welche wiederum vom jeweiligen Betriebszustand sowie von den beiden Gateansteuerungen abhängig sind. Das Schalten eines Dual-Gate GTOs ist also nicht bloss zwingend mit Verzögerungen verbunden, es erfordert auch ein äusserst präzises und vom Betriebszustand abhängiges Timing zwischen den beiden Gateansteuerungen. Das Zeitmuster für die Ansteuerung eines Dual-Gate GTOs ist somit weit komplexer als für einen normalen GTO. Aus diesem Grund hat sich der Dual-Gate GTO in der Praxis nicht durchgesetzt, obschon er seit über 10 Jahren bekannt ist und potentiell erhebliche Vorteile aufweisen könnte.

Der Integrated Gate-Comutated Thyristor (IGCT) wie er in *S.Eicher et al,* "*The 10 kV IGCT - A New Device for Medium Voltage Drives", IEEE-IAS 2000*, beschrieben ist, ist ein weiteres abschaltbares Halbleiterelement mit Abschaltverstärkung gleich oder kleiner als 1 und sehr kurzer Reaktionszeit. Der IGCT ist ein 'hart' angesteuerter Trench GTO. Das Konzept der ,harten' Ansteuerung basiert auf einem neuen Typ von Gateansteuerung und einer sehr niederinduktiven Gateverbindung zum Aktivteil. Daraus ergeben sich eine Reihe von wesentlichen Vorteilen, insbesondere eine äusserst kurze Schaltverzögerungszeit, die Möglichkeit der snubberlosen Schaltung sowie die verbesserte Möglichkeit der Serieschaltung. Gegenüber dem GTO kann ausserdem die Schaltleistung erhöht werden, in der Regel bis zu einer fixen spezifischen Schaltleistung pro Fläche. Damit entfallen auch die komplizierten Skalierungsregeln des GTO. Zudem vermeidet der IGCT durch homogen anfallende spezifische Schaltleistung pro Fläche lokale Überhitzung und damit thermische Instabilität.

### Kurze Darstellung der Erfindung

Die Aufgabe der vorliegenden Erfindung besteht darin, ein Verfahren zum Ansteuern eines Integrated-Gate Dual-Transistors (IGDT) zu schaffen, welches auf die Eigenschaften des IGDTs zugeschnitten ist und somit einen optimalen Betrieb des IGDTs erlaubt, sowie darin, eine Schaltungsanordnung zur Durchführung dieses Verfahrens zu schaffen.
Die Aufgabe wird gelöst mit einem Verfahren mit den Merkmalen des Patentanspruchs 1 sowie einer Schaltungsanordnung mit den Merkmalen der Patentansprüchen 8 oder 9.
Nach dem erfindungsgemässen Verfahren angesteuert können die Stärken des IGDT optimal genutzt werden.
Mit einer harten Ansteuerung je eines oder beider Gates können Schaltverluste durch schnelles Schalten und durch Reduktion des Tail-Stromes minimiert werden.
Insbesondere beim Abschaltvorgang des IGDT führt das harte Ansteuern des anodenseitigen Gates zu einer erheblichen Reduktion der Abschalt-Verluste im Vergleich zum herkömmlichen IGCT, wobei insbesondere andere Einstellungen der der Lebensdauer der Ladungsträger (lifetime control techniques) benutzt werden können.
Das Optimieren von lifetime control kombiniert mit der starken (high-gain) Anodenstruktur ermöglicht eine Reduktion der Durchlassverluste des IGDTs gegenüber herkömmlichen IGCTs um 20 bis 50%.
Durch gleichzeitiges Reduzieren von Schalt- und Durchlassverlusten kann der IGDT für höhere Spannungen (10kV) als der herkömmliche IGCT (6kV) ausgelegt werden.
Durch Begrenzen der Anstiegsgeschwindigkeit der Spannung über dem IGDT über die beiden Gates im Ausschaltvorgang des IGDTs, und/ oder durch Steuern des Sperrstroms zwischen Anode und Kathode über die beiden Gates im ausgeschalteten Zustand des IGDTs, wird der Einsatz des IGDTs in Serienschaltungen erleichtert.
Begrenzung der Anstiegsgeschwindigkeit der Spannung über dem IGDT verhindert, dass in einer Serienschaltung IGDTs unterschiedlich schnell Spannungen aufbauen und so ungleiche Belastungen die einzelnen IGDTs überhitzen oder sogar zerstören. Ebenso im ausgeschalteten Zustand, in dem ungleiche Sperrströme unterschiedliche Spannungsabfälle über einzelnen IGDTs zur Folge hätten, was wiederum zu enormen Belastungen bis hin zur Zerstörung einzelner IGDTs führen würde. Sperrströme können durch das anodenseitige Gate des IGTDs gegenüber herkömmlichen IGCTs um bis zu 50% reduziert werden. Das Erfindungsgemässe Verfahren ermöglicht so die Serienschaltung von abschaltbaren Leistungshalbleitern ohne parallelgeschaltete Widerstände.

Zusätzlich wird der Einsatz des IGDTs in Parallelschaltungen dadurch ermöglicht, dass im Einschaltvorgang des IGDTs die Anstiegsgeschwindigkeit des Anodenstroms über die beiden Gates begrenzt wird.
Durch Begrenzen des Sperrstromes zwischen Anode und Kathode durch beide Gates im ausgeschalteten Zustand, kann der IGDT mit einer höheren Sperrschichttemperatur betrieben werden, wodurch sich die Safe Operating Area (SOA) des IGDT vergrössert.
Das verbesserte thermische Budget, welches dank den obengenannten Vorteilen eingehalten werden kann, erlaubt den IGDT im Vergleich zu herkömmlichen IGCTs mit bis zu 100% höheren Schaltfrequenzen zu betreiben.
Im Gegensatz zu herkömmlichen Dual-Gate GTOs kann mit dem IGDT der Gatestrom eines der Gates während dem Abschalten gesteuert werden. Dadurch lassen sich gefährliche Spannungsspitzen, wie sie etwa auftreten, wenn in Dioden oder Dual-Gate-Halbleitern Ströme plötzlich abreissen (snapp-off), verhindern.
Aus der Gesamtheit der abhängigen Ansprüche ergeben sich weitere vorteilhafte Ausführungsformen.

### Kurze Beschreibung der Zeichnungen

Zum besseren Verständnis und zur Illustration der erzielten Vorteile wird anschliessend die Erfindung anhand der Zeichnungen näher erläutert:
- Fig. 1: zeigt schematisch ein Schnittbild eines Integrated-Gate Dual-Transistors IGDT, mit einem kathodenseitigen ersten Gate und einem anodenseitigen zweiten gate,
- Fig. 2: zeigt ein Schaltsymbol des IGDTs von Fig. 1,
- Fig. 3: zeigt ein Ersatzschaltbild des IGDTs von Fig. 1,
- Fig. 4: zeigt den IGDT von Fig. 1 mit einer kathodenseitigen Gateansteuerung und einer anodenseitigen Gateansteuerung in einem Stack von vier seriengeschalteten IGDTs,
- Figs. 5 bis 7: zeigen verschiedene Ausführungen von Gateansteuerungen für seriengeschaltete IGDTs
- Fig. 8: zeigt ein Beispiel vom Ersatzschaltbild eines IGDTs während einem stromgesteuerten Ausschaltvorgang,
- Fig. 9: zeigt ein Ersatzschaltbild eines IGDTs im ausgeschalteten Zustand
- Figs. 10: zeigt ein Diagramm eines IGDTs in der Ausschaltphase beim beschleunigten Ausschalten ohne Reststrom,
- Figs. 11: zeigt ein Diagramm eines IGDTs in der Ausschaltphase beim Begrenzen der Anstiegsgeschwindigkeit der Anoden-Kathodenspannung,
- Fig. 12: zeigt ein Diagramm eines IGDTs in der Einschaltphase beim Begrenzen der Anstiegsgeschwindigkeit des Anodenstromes,
- Fig. 13: zeigt ein Diagramm eines IGDTs im leitenden Zustand beim Begrenzen des Anodenstromes, und
- Fig. 14: zeigt eine Schaltung zum Testen des IGDTs.

### Weg zur Ausführung der Erfindung

In allen Figuren beziehen sich gleiche Bezugszeichen auf gleichwirkende Teile.
Der Integrated-Gate Dual-Transistor IGDT weist ein vierschichtiges Halbleitersubstrat auf, welches auf beiden Seiten mit jeweils zwei elektrischen Anschlüssen versehen ist.

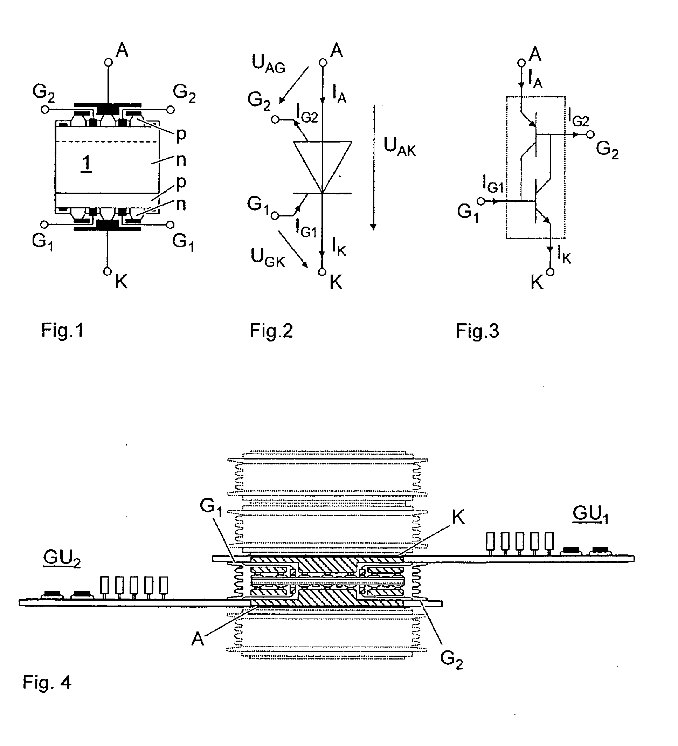

Fig. 1 zeigt schematisch ein Schnittbild des IGDTs mit den vier unterschiedlich dotierten Halbleiterschichten,
- einer anodenseitigen äusseren p-dotierten Anodenschicht,
- einer zweiteiligen, n-dotierten Basisschicht mit integriertem n-Buffer,
- einer p-dotierten Basisschicht sowie
- einer kathodenseitigen äusseren n-dotierten Kathodenschicht.

Beidseitig weist der IGDT jeweils ein Hauptanschluss, Anode A und Kathode K, sowie einen Gateanschluss, kathodenseitig das erste Gate G₁ und anodenseitig das zweite Gate G₂, auf.

Fig. 2 zeigt ein Symbol des IGDTs. In dieser Beschreibung werden für die Spannungen und die Ströme positive Werte in Pfeilrichtung gemäss dieser Darstellung verwendet.

Fig. 3 zeigt ein Erstzschaltbild des IGDTs mit einem anodenseitigen pnp-Transistor sowie einem kathodenseitigen npn-Transistor.

Wie in Fig. 1 angedeutet, sind die beiden Gateanschlüsse rotationssymmetrisch ausgebildet und durch die Hauptanschlüsse hindurch aus dem Gehäuse des IGDTs geführt. Dadurch ergeben sich niederinduktive Anschlüsse mit einer inneren Induktivität von weniger als 100 nH (gemessen zwischen Anode und zweitem Gateanschluss G₂ rsp. Kathode und erstem Gateanschluss G₁ mit einer Metallscheibe anstelle des Halbleitersubstrats).

Fig. 4 zeigt einen IGDT mit Gehäuse und beidseitig angeschlossenen Gateansteuerungseinheiten GU₁ und GU₂ in einem Stapel (Stack) von vier in Serie geschalteten IGDTs. Die Gateansteuerungseinheiten sind wie abgebildet auf einer Leiterplatte angeordnet, welche beitseitig mit einer Metallisierung versehen ist. Auf der Anodenseite beispielsweise, wird die eine, dem IGDT zugewandte Metallisierung mit dem zweiten Gateanschluss G₂ verbunden. Die andere Metallisierung wird mit dem Anodenanschluss verbunden. Dazu wird im Bereich des Anodenanschlusses die Leiterplatte und die Gate-Metallisierung entfernt, so dass der Anodenanschluss durch ein Loch der Leiterplatte die Metallisierung kontaktiert.

Zwischen den beiden aus dem Gehäuse herausgeführten Gateanschlüssen G₁ und G₂ ist ein Isolationsabstand, welcher zumindest der maximalen Betriebsspannung des IGDTs standhält.

Der IGDT ist im sperrenden Zustand, wenn bei der maximal zulässigen Anode-Kathodespannung zwischen Anode und Kathode kein Strom fliesst, der zu einer ständigen Erhöhung der Halbleitertemperatur und letztendlich zur Zerstörung des Halbleiters führen würde.

Der IGDT ist im leitenden Zustand, wenn die Anode-Kathode Leitfähigkeit so gross ist, dass der maximal zulässige Anode-Kathodestrom nicht zu einer ständigen Erhöhung der Halbleitertemperatur und letztendlich einer Zerstörung des Halbleiters führen würde.

Der IGDT kann durch einen positiven Zündstrom an einer der beiden Gateanschlüssen in einen leitenden Zustand zwischen Anode und Kathode versetzt werden.

Bei einem geeigneten Betrieb erlaubt der IGDT beim Übergang vom sperrenden in den leitenden Zustand eine hohe Anstiegsgeschwindigkeit des Anodenstroms, grösser als 20 A/µs/cmₛᵢ².

Bei einem ausreichend grossen Strom (einige Prozente des maximal zulässigen Stroms) zwischen Anode und Kathode erhält das Bauelement auch ohne einen Gatestrom seinen leitenden Zustand

Der IGDT kann durch Anlegen eines ausreichend grossen negativen Gatestromes an einer der Gateanschlüssen oder an beiden gleichzeitig vom leitenden in den sperrenden Zustand versetzt werden.

Beim Übergang vom leitenden in den sperrenden Zustand können in Abhängigkeit der Gateansteuerung sehr hohe Änderungsgeschwindigkeiten des Anodenstroms erreicht werden. Zudem erlaubt der IGDT eine hohe Anstiegsgeschwindigkeit der Spannung zwischen Anode und Kathode (grösser als 1 kV/µs).

Beim Übergang vom leitenden in den sperrenden Zustand ist für den IGDT dank der beidseitig niederinduktiv angesteuerten Gates der Betrieb ohne Snubberschaltung möglich.

Um den IGDT in den leitenden oder sperrenden Zustand zu versetzen, können beide oder nur eines von beiden Gates mit einer Steuerschaltungseinheit betrieben werden. Dabei dürfen an den beiden Gateanschlüssen unterschiedliche Signale geführt werden.

Die Gateansteuerungseinheit muss so ausgelegt sein, dass die für das Betreiben beider Gates notwendige Gateströme mit einer Anstiegsgeschwindigkeit von mehr als 20 A/µs/cmₛᵢ² erzeugt werden können. Die beiden Gateströme müssen gleichzeitig oder zeitlich versetzt erzeugt werden können.

Durch Anlegen eines sehr schnell ansteigenden Gatestromes an das anodeseitge Gate, das kathodenseitige Gate oder gleichzeitig oder zeitlich versetzt an beide Gates schaltet der IGDT sehr schnell ab. Insbesondere beim beidseitig angesteuerten Abschalten verschwindet der beim herkömmlichen GCT vorhandene Tailstrom praktisch ganz, da über die beidseitig angesteuerten Gates Ladungsträger aus dem Innern des IGDT rasch entfernt werden. Dadurch werden Schaltverluste drastisch reduziert. Gegenüber dem herkömmlichen Dual-Gate GTO ist dabei zu beachten, dass die Gates des IGDT vom aktuellen Betriebszustand unabhängig angesteuert werden können und dass insbesondere keine, rsp. eine sehr kleine zeitliche Verzögerung von 0-10µs, insbesondere 0-6µs, zwischen dem ersten und dem zweiten Gatestrom notwendig ist, um den Tailstrom restlos zum verschwinden zu bringen. Die sehr steil ansteigenden Gateströme können somit praktisch synchron in die Gateanschlüsse eingespiesen werden.

Der schnell abfallende Anodenstrom zusammen mit dem Verschwinden des Tail-Stromes bringt eine erhebliche Reduktion der dynamischen Schaltverluste mit sich.

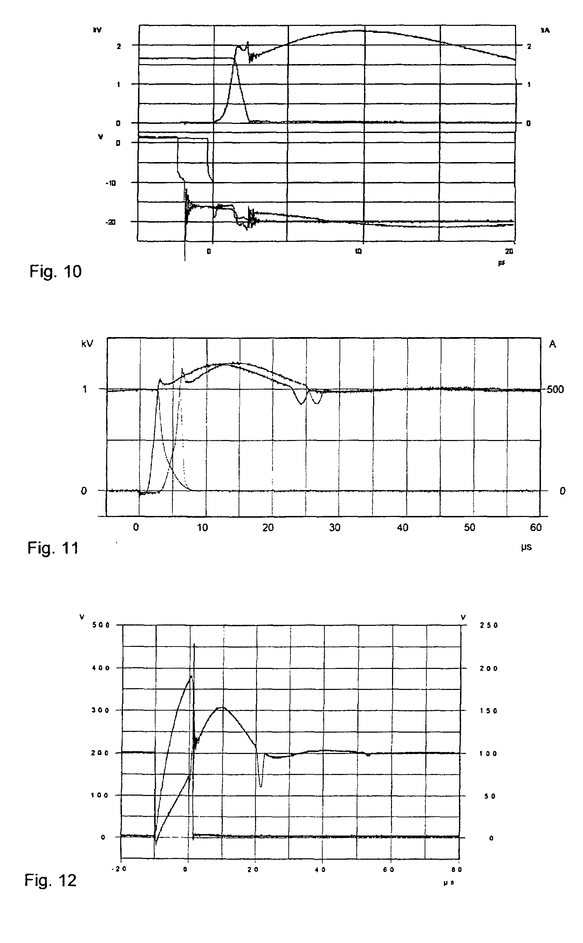

Fig. 10 illustriert das schnelle Abschalten des IGDTs anhand dem zeitlichen Verlauf des Anodenstromes I_{A} und der Anode-Kathodenspannung U_{AK} beim Abschalten mit unterschiedlichen und zeitlich um 2µs versetzten Spannungen an den beiden Gates G₁ und G₂. Im oberen Diagramm sind Anodenstrom I_{A} und Anode-Kathodenspannung U_{AK} über der Zeit aufgezeigt, im unteren Diagramm die beiden Gatespannungen.

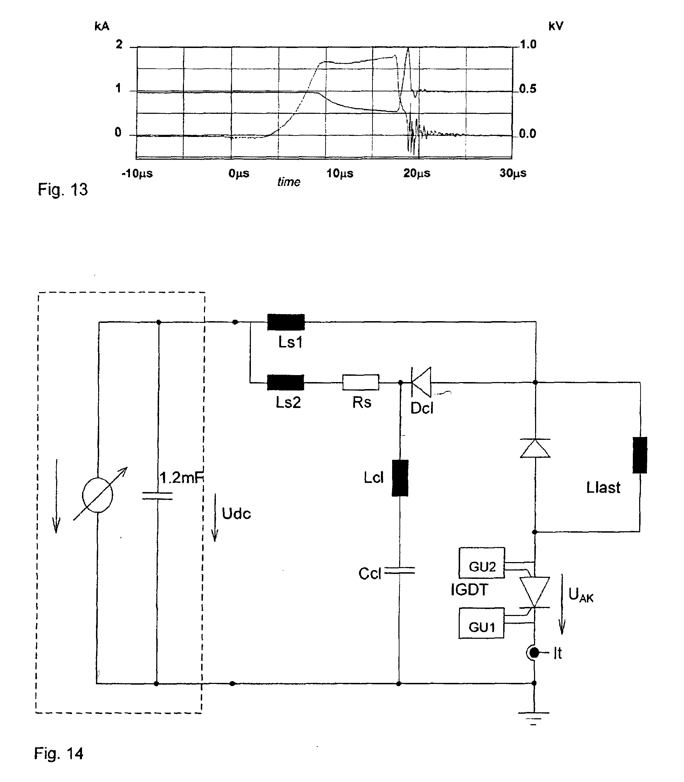

Die in den Fig. 10 bis 13 dargestellte Kurven wurden in einer Testanordnung gemäss Fig. 14 gemessen.

Speziell hervorzuheben ist die verbesserte Einsatzmöglichkeit des IGDT als abschaltbares Leistungshalbleiterelement in Serien- und/ oder Parallelschaltungen. Dabei ist zu beachten, dass die Belastung der in Serie geschalteten Bauelemente im Bereich der Safe Operating Area liegt, um die Lebensdauer der Bauelemente nicht negativ zu beeinträchtigen.

Beispielsweise ist die Änderungsgeschwindigkeit der Anode-Kathodespannung beim Einund Ausschalten des Bauelement zu Begrenzen, damit in der Serienschaltung eine gleichmässige Spannungsverteilung über alle Bauelemente erreicht werden kann.

Oder es ist der Sperrstrom beim ausgeschalteten Zustand zu steuem (vergrössern oder verkleinern), damit wiederum für die Serienschaltung eine gleichmässige Spannungsverteilung über allen Bauteilen erreicht werden kann.

Oder es ist die Änderungsgeschwindigkeit des Anodenstroms beim Ein- und Ausschalten des Bauelements zu Begrenzen, damit in der Parallelschaltung eine gleichmässige Stromverteilung über alle Bauelemente erreicht werden kann.

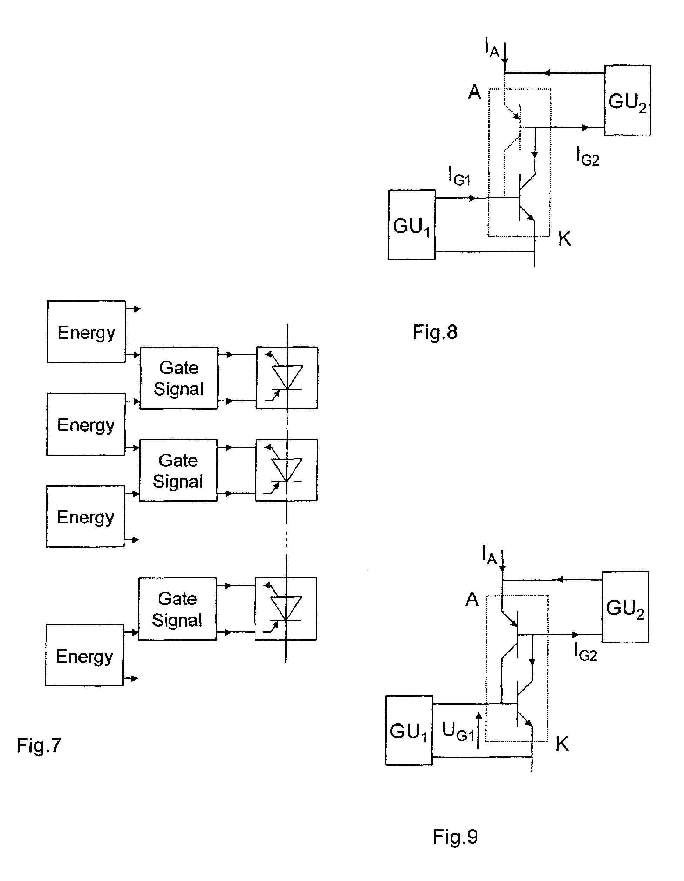

Die Anstiegsgeschwindigkeit der Anode-Kathodespannung kann im Ausschaltvorgang auf drei verschieden Arten begrenzt werden:
1. Indem nur das anodenseitige Gate mit einem stark ansteigenden Gatestrom I_{G2} angesteuert wird.
   Fig. 11 zeigt den Vergleich zwischen einem kathodenseitig und einem anodenseitig abgeschalteten IGDT. Beim kathodenseitig abgeschalteten IGDT fällt der Anodenstrom I_{A} nach 2.5µs stark ab, während die Anoden-Kathodenspannung U_{AK} zwischen 0 und 2.5µs steil ansteigt. Beim anodenseitig abgeschalteten IGDT fällt der Anodenstrom erst nach 6µs steil ab, entsprechend länger und flacher baut sich die Anoden-Kathodenspannung U_{AK} auf.
2. Indem, mit einem stark ansteigenden und ausreichend grossen Gatestrom I_{G2} der Anodenstrom I_{A} auf Null gebracht wird, und anschliessend der kathodenseitige Gatestrom I_{G1} von seinem Maximalwert gleichmässig auf Null zurückgefahren wird. Anhand des Ersatzschaltbildes in Fig. 8 ist dabei ersichtlich, dass der anodenseitige Transistor über die Gateansteuerung kurzgeschlossen wird. Der Kathodenstrom I_{K} wird durch den kathodenseitigen Transistor gleichmässig abgebaut, indem der Gatestrom I_{G1} entsprechend gleichmässig auf Null zurückgefahren wird.
3. Indem mit einem stark ansteigenden und ausreichend grossen Gatestrom I_{G1} der Kathodenstrom auf Null gebracht wird, und anschliessend der anodenseitige Gatestrom I_{G2} von seinem Maximalwert gleichmässig auf Null zurückgefahren wird. Anhand des Ersatzschaltbildes ist dabei ersichtlich, dass der kathodenseitige Transistor über die Gateansteuerung kurzgeschlossen wird. Der Anodenstrom wird durch den anodenseitigen Transistor gleichmässig abgebaut, indem der Gatestrom I_{G2} entsprechend gleichmässig auf Null zurückgefahren wird.

Zum Steuern des Sperrstromes im ausgeschalteten Zustand wird wie in Fig. 9 gezeigt, am kathodenseitigen ersten Gate G₁ eine negative Gatespannung U_{GK} angelegt. Durch Anlegen eines geringen positiven Gatestroms I_{G2} am anodenseitigen Gate wird der Sperrstrom vergrössert. Der positive Gatestrom wird durch den inneren Halbleiter (pnp-Transistor) linear verstärkt (ca. 1:1) wodurch der Sperrstrom anwächst. Eine Verringerung des Sperrstromes ergibt sich aus einer negativen Gatespannung am anodenseitigen Gate U_{AG}. Dank dieser erfindungsgemässen Ansteuerung mindestens zweier in Serie geschalteter IGDT können statische Parallelwiderstände (sharing resistors) zum Ausgleichen von ungleichen Spannungsverteilungen über den Bauelementen weggelassen werden.

Die Anstiegsgeschwindigkeit des Anodenstroms kann im Einschaltvorgang begrenzt werden, indem an einem der beiden Gates eine negative Gatespannung angelegt wird, und das andere Gate mit einem positiven Gatestrom beschaltet wird. Der Verlauf des Anodenstromes ist folglich abhängig von der Last, vom Verlauf des Gatestromes sowie von der Auslegung des Halbleiters. Ein entsprechendes Beispiel ist in Fig. 12 dargestellt. Im Bereich von -10 bis 0µs wird am zweiten Gate G₂ eine negative Gatespannung U_{AG} = 20V angelegt und am ersten Gate G₁ ein positiver Gatestrom von I_{G1}>50A eingespiesen. Im Gegensatz zum IGCT zündet der IGDT in diesem Fall nicht, sondern lässt den Anodenstrom I_{A} über den positiven Gatestrom I_{G1} steuern. Ein typischer Verstärkungsfaktor beträgt dabei 500.

Der IGDT kann sowohl vom eingeschalteten als vom ausgeschalteten Zustand in einen stromgeführten Zustand gebracht werden. Der Anodenstrom wird hierbei direkt von den Gateströmen bestimmt. Hierzu wird das anodenseitige zweite Gate G₂ ausgeschaltet (mit einem ausreichend grossen negativen Gatestrom I_{G2} wird der Anodenstrom I_{A} 'umgeleitet'), so dass sich kathodenseitig ein vom kathodenseitigen ersten Gatestrom I_{G1} geführter Laststrom einstellt. Auf diese Weise kann im eingeschalteten Zustand ein Anodenüberstrom oder im Ausschattvorgang eine Anoden-Kathodenüberspannung verhindert oder schnell abgebaut werden.

Fig. 13 zeigt ein entsprechendes Beispiel. Zum Zeitpunkt 0µs wird das zweite Gate G₂ ausgeschaltet während das erste Gate G₁ weiter mit 10A angesteuert wird. Anodenseitig steigt die Gatespannung U_{AG} innert 10µs auf ihren Maximalwert (ca. 800-900V) an, während der Anodenstrom I_{A} auf einen Lastunabhängigen Wert (500A) abfällt. Nach 18µs wird das zweite Gate G₂ wieder eingeschaltet.

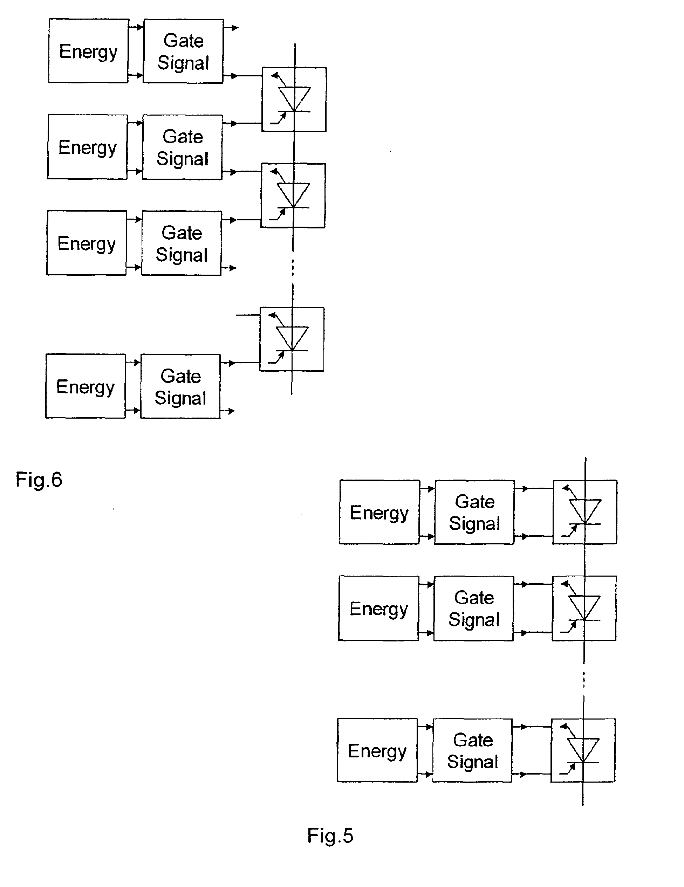

Die Fig. 5 bis 7 zeigen verschiedene Möglichkeiten, wie die Gateanschlüsse für mehrere seriengeschaltete IGDTs angeordnet und mit Energie versorgt werden können. Der Vorteil der dargestellten Anordnungen liegt in der Minimierung der Kosten zur Ansteuerung der seriengeschalteten Bauelemente.

Eine Gateansteuerung umfasst jeweils zwei Gateansteuerungseinheiten, welche wiederum getrennt oder gemeinsam von einer Energieversorgungseinheit gespiesen werden.

In Fig. 5 zeigt eine erste Anordnung, bei welcher die beiden Gateansteuerungseinheiten je das erste Gate G₁ und das zweite Gate G₂ eines IGDTs ansteuern. Die Energieversorgungen der beiden Ansteuerungseinheiten sind gekoppelt. Die gesamte Energie wird entweder von einer externen Schaltung oder von der Anoden-Kathodenspannung des angesteuerten IGDTs bezogen. Auf diese Weise sind für n IGDTs nur n Gateansteuerungen notwendig.

Fig. 6 zeigt eine zweite Anodnung, bei welcher von einer Gateansteuerung die beiden benachbarten, und auf gleichem Potential liegenden Gates zweier seriegeschalteter IGDTs angesteuert werden. Die Energieversorgungen zur Steuerung der beiden Gates sind direkt miteinander gekoppelt und bilden wiederum einen Einheit. Auf diese Weise sind für n IGDTs n+1 Gateansteuerungen notwendig.

Fig. 7 zeigt schliesslich eine dritte Anordnung, bei welcher von einer Gateansteuerung wiederum die beiden benachbarten Gates zweier serigeschalteter IGDTs angesteuert werden. Allerdings sind die Energieversorgungen gemäss der ersten Anordnung ausgeführt, womit jeder IGDT eine eigene Energieversorgung für seine beiden Gates aufweist.

### Bezugszeichenliste

- 1: Halbleitersubstrat
- A: Anode
- G₁, G₂: Gate
- GU₁, GU₂: Gateansteuerungseinheiten
- I_{A}, I_{K}: Anodenstrom, Kathodenstrom
- I_{G1}, I_{G2}: Gatestrom
- K: Kathode
- U_{AG}, U_{GK}: Gatespannung
- U_{AK}: Anode-Kathodenspannung

## Patentansprüche

1. Verfahren zum Ansteuern eines Leistungshalbleiterelementes, wobei das Leistungshalbleiterelement ein Integrated-Gate Dual-Transistor (IGDT) ist, welcher
- zwischen einer Anode (A) und einer Kathode (K) ein vierschichtiges Halleitersubstrat (1), mit
- einer anodenseitigen äusseren p-dotierten Anodenschicht,
- einer zweiteiligen, n-dotierten Basisschicht mit integriertem n-Buffer,
- einer p-dotierten Basisschicht sowie
- einer kathodenseitigen äusseren n-dotierten Kathodenschicht,
- sowie zwei über niederinduktive Gatanschlüsse steuerbare Gates (G₁, G₂) umfasst,
bei welchem Verfahren durch hartes Ansteuern nur des ersten Gates (G1), nur des zweiten Gates (G₂) oder gleichzeitig oder zeitlich versetzt beider Gates, oder durch hartes Steuern eines der beiden Gates und Strom- oder Spannungssteuern des anderen Gates
- im Ausschaltvorgang des IGDTs die Schaltverluste über die beiden Gates (G₁, G₂) reduziert werden, und/ oder
- im Ausschaltvorgang des IGDTs die Anstiegsgeschwindigkeit der Spannung (U_{AK}) über dem IGDT über die beiden Gates (G₁, G₂) begrenzt wird, und/ oder
- im ausgeschalteten Zustand des IGDTs der Sperrstrom (I_{A}) zwischen Anode und Kathode über die beiden Gates (G₁, G₂) gesteuert wird, undl oder
- im Einschaltvorgang des IGDTs die Anstiegsgeschwindigkeit des Anodenstroms (I_{A}) über die beiden Gates (G₁, G₂) begrenzt wird, und/ oder
- im eingeschalteten Zustand des IGDTs der Anodenstrom (I_{A}) über die beiden Gates (G₁, G₂) begrenzt und/ oder gesteuert wird.

2. Verfahren nach Anspruch 1, **dadurch gekennzeichnet, dass**
- die Schaltverluste reduziert werden, indem
- in der Anfangsphase des Ausschaltvorgangs der zweite Gatestrom (I_{G2})mit einer Anstiegsgeschwindigketi von mehr als 20 A/µs/cmₛᵢ² aufgebaut wird, und
- bis zu 6 µs nach dem zweiten Gatestrom (I_{G2}) auch der erste Gatestrom (I_{G1}) mit einer Anstiegsgeschwindigketi von mehr als 20 A/µs/cmₛᵢ² aufgebaut wird.

3. Verfahren nach einem der Ansprüche 1 oder 2, **dadurch gekennzeichnet, dass**
- die Anstiegsgeschwindigkeit der Anodenspannung begrenzt wird, indem entweder
- durch einen mit einer Anstiegsgeschwindigketi von mehr als 20 A/µs/cmₛᵢ² ansteigenden ersten Gatestroms (I_{G1}) der Kathodenstrom (I_{K}) auf Null gebracht wird, und
- anschliessend der zweite Gatestrom (I_{G2}) von seinem Maximalwert auf Null zurückgefahren wird,
- oder
- durch einen mit einer Anstiegsgeschwindigketi von mehr als 20 A/µs/cmₛᵢ² ansteigenden zweiten Gatestroms (I_{G2}) der Anodenstrom (I_{A}) auf Null gebracht wird, und
- anschliessend der erste Gatestrom (I_{G1}) von seinem Maximalwert auf Null zurückgefahren wird.

4. Verfahren nach einem der Ansprüche 1 bis 4, **dadurch gekennzeichnet, dass**
- der Sperrstrom (I_{A}) gesteuert wird, indem
- das erste Gate (G₁) mit einer negativen Spannung (U_{GK}) beaufschlagt wird, und
- zum Vergrössern des Sperrstroms (I_{A}) ein positiver zweiter Gatestrom (I_{G2}) am zweiten Gate (G₂) angelegt wird, und
- zum Verkleinern des Sperrstroms (I_{A}) das zweite Gate (G₂) mit einer negativen Spannung (U_{AG}) beaufschlagt wird.

5. Verfahren nach einem der Ansprüche 1 bis 5, **dadurch gekennzeichnet, dass**
- die Anstiegsgeschwindigkeit des Anodenstroms (I_{A}) begrenzt wird, indem entweder
- das erste Gate (G₁) mit einer kontinuierlichen negativen Gatespannung (U_{AK}) beaufschlagt wird, und
- der Aufbau des Anodenstroms (I_{A}) über einen positiven Gatestrom (I_{G2}) am zweiten Gate (G₂) gesteuert wird,
oder
- das zweite Gate (G₂) mit einer kontinuierlichen negativen Gatespannung (U_{AG}) beaufschlagt wird, und
- der Aufbau des Anodenstroms (I_{A}) über einen positiven Gatestrom (I_{G1}) am ersten Gate (G₁) gesteuert wind.

6. Verfahren nach einem der Ansprüche 1 bis 6, **dadurch gekennzeichnet, dass**
- der Anodenstroms (I_{A}) begrenzt und/ oder gesteuert wird, indem entweder
- das erste Gate (G₁) mit einem negativen Gatestrom (I_{G1}) mit einer Anstiegsgeschwindigketi von mehr als 20 A/µs/cmₛᵢ² ausgeschaltet wird, und
- der Anodenstroms (I_{A}) über einen positiven Gatestrom (I_{G2}) am zweiten Gate (G₂) gesteuert wird,
oder
- das zweite Gate (G₂) mit einem negativen Gatestrom (I_{G2}) mit einer Anstiegsgeschwindigketi von mehr als 20 A/µs/cmₛᵢ² ausgeschaltet wird, und
- der Anodenstroms (I_{A}) über einen positiven Gatestrom (I_{G1}) am ersten Gate (G₁) gesteuert wird.

7. Schaltungsanordnung zum Durchführen des Verfahrens nach einem der Ansprüche 1 bis 7, umfassend
- eine Serienschaltung von IGDTs mit jeweils zwei steuerbaren Gates, wobei ein erstes Gate kathodenseitig angebracht ist, und ein zweites Gate anodenseitig angebracht ist,
- mehrere Gateansteuerungen umfassend zwei Steuereinheiten zum Ansteuern von jeweils einem Gate,
- mehrere Einheiten zur Energieversorgung der Gatesansteuerungen,
wobei
- eine erste Steuereinheit einer Gateansteuerung jeweils ein kathodenseitiges Gate eines ersten IGDTs ansteuert, und
- eine zweite Steuereinheit der Gateansteuerung jeweils ein anodenseitiges Gate eines anodenseitig mit der Kathode des ersten IGDTs verbundenen zweiten IGDTs ansteuert.

8. Schaltungsanordnung zum Durchführen des Verfahrens nach einem der Ansprüche 1 bis 7, umfassend
- eine Serienschaltung von IGDTs mit jeweils zwei steuerbaren Gates, wobei ein erstes Gate kathodenseitig angebracht ist, und ein zweites Gate anodenseitig angebracht ist,
- mehrere Gateansteuerungen umfassend zwei Steuereinheiten zum Ansteuern von jeweils einem Gates,
- Einheiten zur Energieversorgung der Gateansteuerungen,
wobei
- die beiden Steuereinheiten einer Gateansteuerung jeweils die beiden Gates eines einzelnen IGDTs ansteuem.

9. Schaltungsanordnung nach einem der Ansprüche 8 oder 9, **dadurch gekennzeichnet, dass**
- eine Energieversorgungseinheit jeweils beide Steuereinheiten einer Gateansteuerung mit Energie versorgen.

10. Schaltungsanordnung nach einem der Ansprüche 8 oder 9, **dadurch gekennzeichnet, dass**
- eine Energieversorgungseinheit eine zweite Steuereinheit einer ersten Gateansteuerung undl oder eine erste Steuereinheit einer zweiten Gateansteuerung mit Energie versorgen.

## Geänderte Patentansprüche

### Geänderte Patentansprüche gemäss Regel 86(2) EPÜ.

**4.** Verfahren nach einem der Ansprüche 1 bis 3, **dadurch gekennzeichnet, dass**
- der Sperrstrom (I_{A}) gesteuert wird, indem
- das erste Gate (G₁) mit einer negativen Spannung (U_{GK}) beaufschlagt wird, und
- zum Vergrössern des Sperrstroms (I_{A}) ein positiver zweiter Gatestrom (I_{G2}) am zweiten Gate (G₂) angelegt wird, und
- zum Verkleinern des Sperrstroms (I_{A}) das zweite Gate (G₂) mit einer negativen Spannung (U_{AG}) beaufschlagt wird.

**5.** Verfahren nach einem der Ansprüche 1 bis 4, **dadurch gekennzeichnet, dass**
- die Anstiegsgeschwindigkeit des Anodenstroms (I_{A}) begrenzt wird, indem entweder
- das erste Gate (G₁) mit einer kontinuierlichen negativen Gatespannung (U_{AK}) beaufschlagt wird, und
- der Aufbau des Anodenstroms (I_{A}) über einen positiven Gatestrom (I_{G2}) am zweiten Gate (G₂) gesteuert wird,
oder
- das zweite Gate (G₂) mit einer kontinuierlichen negativen Gatespannung (U_{AG}) beaufschlagt wird, und
- der Aufbau des Anodenstroms (I_{A}) über einen positiven Gatestrom (I_{G1}) am ersten Gate (G₁) gesteuert wird.

**6.** Verfahren nach einem der Ansprüche 1 bis 5, **dadurch gekennzeichnet, dass**
- der Anodenstroms (I_{A}) begrenzt und/ oder gesteuert wird, indem entweder
- das erste Gate (G₁) mit einem negativen Gatestrom (I_{G1}) mit einer Anstiegsgeschwindigketi von mehr als 20 A/µs/cmₛᵢ² ausgeschaltet wird, und
- der Anodenstroms (I_{A}) über einen positiven Gatestrom (I_{G2}) am zweiten Gate (G₂) gesteuert wird,
oder
- das zweite Gate (G₂) mit einem negativen Gatestrom (I_{G2}) mit einer Anstiegsgeschwindigketi von mehr als 20 A/µs/cmₛᵢ² ausgeschaltet wird, und
- der Anodenstroms (I_{A}) über einen positiven Gatestrom (I_{G1}) am ersten Gate (G₁) gesteuert wird.

**7.** Schaltungsanordnung zum Durchführen des Verfahrens nach einem der Ansprüche 1 bis 6, umfassend
- eine Serienschaltung von IGDTs mit jeweils zwei steuerbaren Gates, wobei ein erstes Gate kathodenseitig angebracht ist, und ein zweites Gate anodenseitig angebracht ist,
- mehrere Gateansteuerungen umfassend zwei Steuereinheiten zum Ansteuern von jeweils einem Gate,
- mehrere Einheiten zur Energieversorgung der Gatesansteuerungen,
wobei
- eine erste Steuereinheit einer Gateansteuerung jeweils ein kathodenseitiges Gate eines ersten IGDTs ansteuert, und
- eine zweite Steuereinheit der Gateansteuerung jeweils ein anodenseitiges Gate eines anodenseitig mit der Kathode des ersten IGDTs verbundenen zweiten IGDTs ansteuert.

**8.** Schaltungsanordnung zum Durchführen des Verfahrens nach einem der Ansprüche 1 bis 6, umfassend
- eine Serienschaltung von IGDTs mit jeweils zwei steuerbaren Gates, wobei ein erstes Gate kathodenseitig angebracht ist, und ein zweites Gate anodenseitig angebracht ist,
- mehrere Gateansteuerungen umfassend zwei Steuereinheiten zum Ansteuern von jeweils einem Gates,
- Einheiten zur Energieversorgung der Gateansteuerungen,
wobei
- die beiden Steuereinheiten einer Gateansteuerung jeweils die beiden Gates eines einzelnen IGDTs ansteuern.

**9.** Schaltungsanordnung nach einem der Ansprüche 7 oder 8, **dadurch gekennzeichnet, dass**
- eine Energieversorgungseinheit jeweils beide Steuereinheiten einer Gateansteuerung mit Energie versorgen.

**10.** Schaltungsanordnung nach einem der Ansprüche 7 oder 8, **dadurch gekennzeichnet, dass**
- eine Energieversorgungseinheit eine zweite Steuereinheit einer ersten Gateansteuerung und/ oder eine erste Steuereinheit einer zweiten Gateansteuerung mit Energie versorgen.
